# EUROPEAN PATENT APPLICATION

(11) **EP 2 469 606 A2**
(43) Date of publication of application: **27.06.2012**
(21) Application number: 10810120.5
(22) Date of filing: 13.08.2010
(51) Int. Cl.: H01L 31/042, H01L 21/306

(54) **TRENCH LINE FOR THE DISCONNECTION OF A SOLAR CELL**

(30) Priority: 18.08.2009 KR 20090076232
(71) Applicant: Hyundai Heavy Industries Co., Ltd., Ulsan 682-792 (KR)
(72) Inventor: LEE, Sang Seop, Seoul 134-030 (KR); SONG, Seok Hyun, Yongin-si Gyeonggi-do 446-567 (KR); KANG, Gil Joo, Chungju-si Chungcheongbuk-do 380-956 (KR); PARK, Jun Young, Chungju-si Chungcheongbuk-do 380-090 (KR); SHIN, Jong Su, Eumseong-gun Chungcheongbuk-do 369-807 (KR)
(74) Representative: Wallin, Nicholas James
(86) International application number: PCT/KR2010/005344
(87) International publication number: WO 2011/021812

(57) **Abstract**

Provided is a trench line for the disconnection of a solar cell, capable of effectively insulating a semiconductor layer at an upper portion of a substrate from a semiconductor layer at a side portion of the substrate and improving disconnection reliability. The trench line for the disconnection of a solar cell according to the disclosure which electrically insulates the semiconductor layers formed at the upper portion and the side portion of the substrate of the solar cell from each other, includes a plurality of unit trench lines which are disposed to intersect at an upper surface of the substrate of the solar cell. Intersecting points of the intersecting unit trench lines are positioned on the unit trench lines and are positioned at points spaced inwardly from starting points or ending points of the unit trench lines by a predetermined distance.

## Description

### [Technical Field]

The following disclosure relates to a trench line for the disconnection of a solar cell, capable of effectively insulating a semiconductor layer at an upper portion of a substrate from a semiconductor layer at a side portion of the substrate and improving disconnection reliability.

### [Background Art]

A solar cell is the key element in photovoltaic power generation for converting sunlight directly into electricity, and is a diode based on the p-n function.

In a process of converting sunlight into electricity by the solar cell, when sunlight is incident onto a p-n junction portion of the solar cell, an electron-hole pair is generated, and the electron and the hole are respectively moved to an n layer and a p layer by an electric field, such that photovoltaic power is generated at the p-n junction portion. Here, when a load or a system is connected to both ends of the solar cell, current flows and thus power may be generated.

Meanwhile, solar cells vary depending on the material of a light-absorbing layer which is a p-n function layer. Silicon (Si) may be representatively employed as the light-absorbing layer, and such silicon-based solar cells are classified into substrate types which use a silicon wafer as a light-absorbing layer, and thin-film types which form a light-absorbing layer by depositing silicon into a thin film shape.

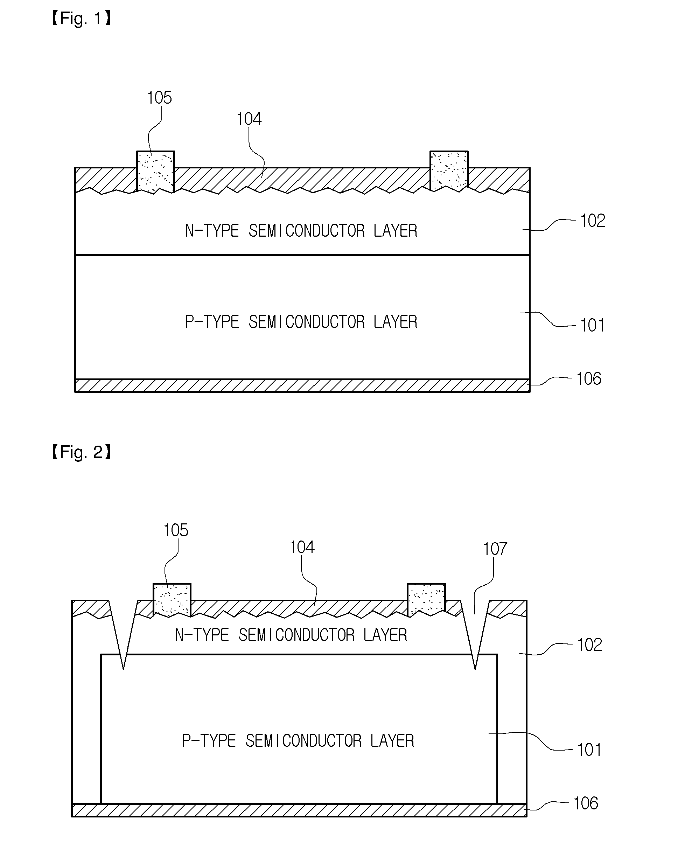

The structure of the substrate type of the silicon-based solar cells will be described as follows. As illustrated in FIG. 1, an n-type semiconductor layer 102 is provided on a p-type semiconductor layer 101, and a front surface electrode 105 and a rear surface electrode 106 are respectively provided at the upper portion of the n-type semiconductor layer 102 and the lower portion of the p-type semiconductor layer 101. Here, the p-type and n-type semiconductor layers 101 and 102 are implemented in a single substrate so that the lower portion of the substrate is the p-type semiconductor layer 101 and the upper portion of the substrate is the n-type semiconductor layer 102. In general, in a state where a p-type silicon substrate is prepared, n-type impurity ions are injected and diffused into the upper layer portion of the p-type silicon substrate, thereby forming the n-type semiconductor layer 102. In addition, an anti-reflection film 104 for minimizing surface reflection is provided on the n-type semiconductor layer 102.

Meanwhile, the process of forming the n-type semiconductor layer 102 is performed in such a method that n-type impurity ions are generally injected into a substrate using a solution containing the n-type impurity ions and the n-type impurity ions are diffused into the upper portion of the substrate through a subsequent heat treatment process. Here, the solution containing the n-type impurity ions are brought into contact not only with the upper surface of the substrate but also with the side surface of the substrate, so that the n-type semiconductor layer 102 is substantially formed at the side portion of the substrate as well as the upper portion of the substrate as illustrated in FIG. 2.

The n-type semiconductor layer formed at the side portion of the substrate causes the front surface electrode and the rear surface electrode to be short-circuited, and thus becomes the factor in the degradation of photoelectric conversion efficiency. Therefore, electrical connection between the front surface electrode and the rear surface electrode by the n-type semiconductor layer at the side portion has to be prevented, and for this, according to the related art, a method of forming a trench for disconnection along the circumference of the substrate is employed.

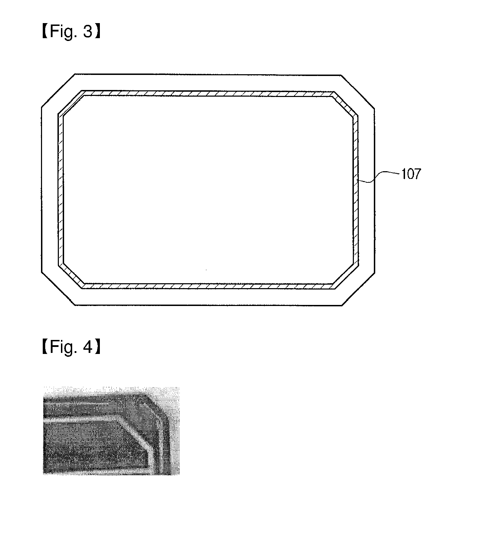

As illustrated in FIG. 2, a trench 107 for disconnection is formed into a depth greater than the thickness of the n-type semiconductor layer at the upper portion of the substrate and has a role of insulating the n-type semiconductor layer at the upper portion of the substrate from the n-type semiconductor layer at the side portion of the substrate. In addition, the trench 107 for disconnection is configured in the shape of a looped curve along the circumference of the substrate on the upper surface of the substrate as illustrated in FIG. 3.

Meanwhile, the trench for disconnection is generally formed by removing a portion of the substrate using a laser. Here, due to misalignment during an operation using the laser, a phenomenon in which the trench line is not formed in the shape of the looped curve and a part of the trench line is open occurs sometimes (see the upper end of FIG. 4). As such, the open part of the trench line for disconnection means that the n-type semiconductor layers at the upper portion and the n-type semiconductor at the side portion are electrically connected to each other, and eventually means that the front and rear surface electrodes are short-circuited. Therefore, the basic function of the trench for disconnection is lost.

### [Disclosure]

### [Technical Problem]

An embodiment of the present disclosure is directed to providing a trench line for insulation of a solar cell, capable of effectively insulating a semiconductor layer at an upper portion of a substrate from a semiconductor layer at a side portion of the substrate and improving insulation reliability.

### [Technical Solution]

In one general aspect, a trench line for the disconnection of a solar cell, which electrically insulates semiconductors formed at an upper portion and a side portion of a substrate of the solar cell from each other, includes: a plurality of unit trench lines which are disposed to intersect at an upper surface of the substrate of the solar cell, wherein intersecting points of the intersecting unit trench lines are positioned on the unit trench lines and are positioned at points spaced inwardly from starting points or ending points of the unit trench lines by a predetermined distance. Here, the starting point and the ending point of each of the unit trench line may be both ends of the substrate.

### [Advantageous Effects]

The trench line for the disconnection of a solar cell according to the disclosure has the following advantages.

A plurality of unit trench lines are disposed to intersect and the intersecting points are configured so as not to be the same as starting points or ending points of the unit trench lines. Therefore, even in a case where a substrate is misaligned during formation of the trench line for disconnection using a laser, a process margin is ensured to some extent, and thus the trench line for disconnection may be easily formed. In addition, reliability of the formed trench line for disconnection may be enhanced.

### [Description of Drawings]

The above and other objects, features and advantages of the present disclosure will become apparent from the following description of certain exemplary embodiments given in conjunction with the accompanying drawings, in which:
FIGS. 1 and 2 are cross-sectional views of a general solar cell.
FIG. 3 is a plan view illustrating a trench for disconnection of a solar cell according to related art.
FIG. 4 is a photograph showing a case where an open region is formed in a trench for the disconnection of the solar cell according to the related art.
FIG. 5 is a plan view of a solar cell, illustrating a trench line for the disconnection of the solar cell according to an embodiment of the disclosure.
FIG. 6 is a plan view of the solar cell, illustrating a trench line for the disconnection of the solar cell according to another embodiment of the disclosure.

### [Best Mode]

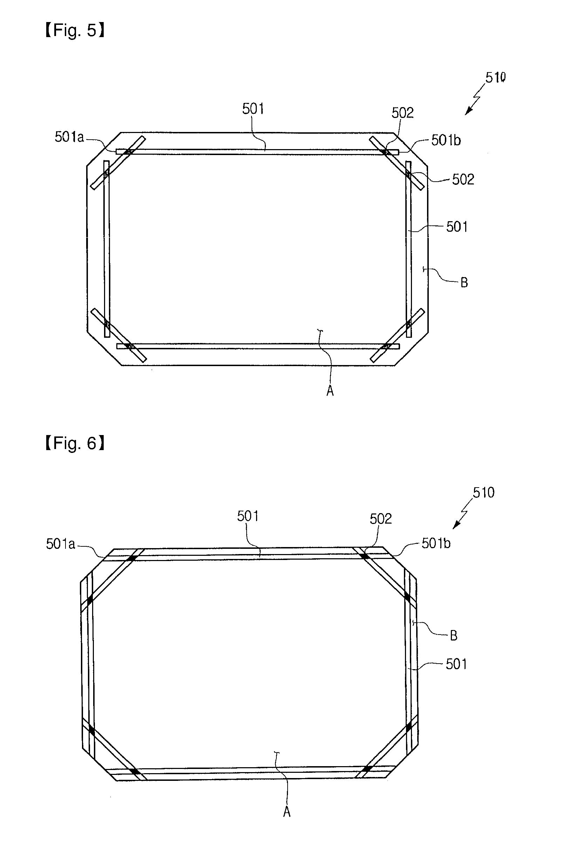

Hereinafter, a trench line for the disconnection of a solar cell according to an embodiment of the disclosure will be described in detail with reference to the drawings. FIG. 5 is a plan view of a solar cell, illustrating a trench line for the disconnection of the solar cell according to an embodiment of the disclosure.

As illustrated in FIG. 5, a trench line 510 for the disconnection of the solar cell according to the embodiment of the disclosure is formed on the upper surface of the solar cell and has a role of electrically insulating an outside semiconductor layer B and an inside semiconductor layer A. In order to electrically insulate the outside semiconductor layer from the inside semiconductor layer, the depth of the trench line 510 for disconnection has to be greater than the thickness of the semiconductor layer.

The outside semiconductor layer and the inside semiconductor layer are formed at the same time by a process of forming the semiconductor layer of the solar cell and the regions thereof are divided by the trench line 510 for disconnection. When a substrate is a first conductive type, the semiconductor layer is made of a second conductive type. In addition, the region of the inside semiconductor layer defined by the trench line 510 for disconnection corresponds to a practical light-receiving region of the solar cell. In order to maximize the light-receiving region, the trench line 510 for disconnection may be formed at a position close to the border of the solar cell.

Meanwhile, the trench line 510 for disconnection according to the disclosure is configured of a plurality of unit trench lines 501 which are disposed to intersect. Here, intersecting points 502 of the unit trench lines 501 that intersect during intersecting of the unit trench lines 501 are not the same as the starting points 501 a or ending points 501 b of the unit trench lines 501. In other words, during the intersecting of the unit trench lines 501, the starting point 501 a or the ending point 501 b of the unit trench line 501 does not come in contact with the starting points 501 a or the ending points 501 b of other unit trench lines 501. In other words, points spaced inwardly from the starting points 501 a or the ending points 501 b by a predetermined distance are the intersecting points 502 of the unit trench lines 501. Accordingly, the four unit trench lines 501 are disposed in a radial form around the intersecting points 502, and the four unit trench lines 501 mean a pair of the intersecting unit trench lines 501.

As such, under the condition in which it is satisfied that the trench line 510 for disconnection electrically insulates the inside semiconductor layer from the outside semiconductor layer and the intersecting points 502 of the unit trench lines 501 are not the same as the starting points 501 a or the ending points 501 b, the shape of the trench lines 510 for disconnection and the intersecting forms of the unit trench lines 501 may be modified in various manners.

First, the shape of the trench lines 510 for disconnection may be configured as various shapes such as a rectangular or polygonal shape. For example, the trench line 510 for disconnection which is rectangular may be implemented through the arrangement of four orthogonal unit trench lines 501, and the trench line 510 which is polygonal may be configured through the arrangement of the unit trench lines 501 required by the corresponding angular shape.

In addition, during implementation of the intersecting form of the unit trench line 501, in order to increase the intersection reliability of the unit trench lines 501, as illustrated in FIG. 6, the starting point 501 a and the ending point 501 b of each unit trench line 501 may be designed to be at ends of a substrate. That is, in a state where the unit trench lines 501 are configured so that one end of the substrate is the starting point 501 a and the other end of the substrate is the ending point 501 b, the unit trench lines 501 may intersect. Here, of course, the intersecting points 502 of the unit trench lines 501 are not the same as the starting point 501 a and the ending point 501 b.

As such, by disposing the plurality of unit trench lines 501 to intersect, the intersecting points 502 are configured so as not to be the same as the starting point 501 a or the ending point 501 b of the unit trench line 501 when the trench line 510 for disconnection is configured to insulate the semiconductor layer at the upper portion of the substrate from the semiconductor layer at the side portion of the substrate. Therefore, even in a case where the substrate is misaligned during formation of the trench line 510 for disconnection using a laser, a process margin is ensured to some extent, and thus the trench line 510 for disconnection may be easily formed. In addition, reliability of the formed trench line 510 for disconnection may be enhanced.

A plurality of unit trench lines are disposed to intersect and the intersecting points are configured so as not to be the same as starting points or ending points of the unit trench lines. Therefore, even in a case where a substrate is misaligned during formation of the trench line for disconnection using a laser, a process margin is ensured to some extent, and thus the trench line for disconnection may be easily formed. In addition, reliability of the formed trench line for disconnection may be enhanced.

## Claims

1. A trench line for the disconnection of a solar cell, which electrically insulates semiconductor layers formed at an upper portion and a side portion of a substrate of the solar cell from each other, comprising:
a plurality of unit trench lines which are disposed to intersect at an upper surface of the substrate of the solar cell,
wherein intersecting points of the intersecting unit trench lines are positioned on the unit trench lines and are positioned at points spaced inwardly from starting points or ending points of the unit trench lines by a predetermined distance.

2. The trench line according to claim 1, wherein the starting point and the ending point of each of the unit trench line are both ends of the substrate.
